(19) Europäisches Patentamt
European Patent Office
Office européen des brevets

(11) **EP 3 290 940 B1**

(12) # EUROPÄISCHE PATENTSCHRIFT

(45) Veröffentlichungstag und Bekanntmachung des Hinweises auf die Patenterteilung:
**31.05.2023 Patentblatt 2023/22**

(21) Anmeldenummer: **17164571.6**

(22) Anmeldetag: **03.04.2017**

(51) Internationale Patentklassifikation (IPC):
**G01R 33/483** (2006.01)   **G01R 33/56** (2006.01)
**G01R 33/561** (2006.01)

(52) Gemeinsame Patentklassifikation (CPC):
**G01R 33/5608; G01R 33/4835; G01R 33/5611**

(54) **ITERATIVE REKONSTRUKTION VON QUANTITATIVEN MR-BILDERN**

ITERATIVE RECONSTRUCTION OF QUANTITATIVE MR IMAGES

RECONSTRUCTION ITÉRATIVE D'IMAGES RM QUANTITATIVES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**07.03.2018 Patentblatt 2018/10**

(73) Patentinhaber: **Siemens Healthcare GmbH**
**91052 Erlangen (DE)**

(72) Erfinder:
• **Hilbert, Tom**
**1018 Lausanne (CH)**
• **Kober, Tobias**
**1007 Lausanne (CH)**

(56) Entgegenhaltungen:
**WO-A1-2016/171759**

• **NING LIPENG ET AL: "A joint compressed-sensing and super-resolution approach for very high-resolution diffusion imaging", NEUROIMAGE, Bd. 125, 23. Oktober 2015 (2015-10-23), Seiten 386-400, XP029352263, ISSN: 1053-8119, DOI: 10.1016/J.NEUROIMAGE.2015.10.061**
• **GWENDOLYN VAN STEENKISTE ET AL: "Super-resolution T 1 estimation: Quantitative high resolution T1 mapping from a set of low resolution T1-weighted images with different slice orientations : Super-Resolution T1 Estimation", MAGNETIC RESONANCE IN MEDICINE., Bd. 77, Nr. 5, 1. Juli 2016 (2016-07-01), Seiten 1818-1830, XP055419926, US ISSN: 0740-3194, DOI: 10.1002/mrm.26262**
• **YANHONG LU ET AL: "Super resolution image reconstruction in parallel magnetic resonance imaging", CONTROL AND AUTOMATION (ICCA), 2010 8TH IEEE INTERNATIONAL CONFERENCE ON, IEEE, PISCATAWAY, NJ, USA, 9. Juni 2010 (2010-06-09), Seiten 761-766, XP031716827, ISBN: 978-1-4244-5195-1**
• **ERIC VAN REETH ET AL: "Super-resolution in magnetic resonance imaging: A review", CONCEPTS IN MAGNETIC RESONANCE PART A, Bd. 40A, Nr. 6, 1. November 2012 (2012-11-01), Seiten 306-325, XP55046660, ISSN: 1546-6086, DOI: 10.1002/cmr.a.21249**

**EP 3 290 940 B1**

**Beschreibung**

Die vorliegende Erfindung betrifft ein Verfahren zur Erstellung von quantitativen MR-Bildern eines Untersuchungsobjekts und die zugehörige MR-Anlage hierfür. Weiterhin sind ein Computerprogrammprodukt und ein elektronisch lesbarer Datenträger vorgesehen.

Die Magnetresonanztomographie (MRT) ist eine inhärent langsame Bildgebungstechnik, was zu langen Messzeiten führen kann. Jedoch liefert die MRT sehr brauchbare Bildkontraste. Insbesondere ist der Weichteilkontrast mit der klinischen Information in MR-Bildern gut ausgebildet, sodass MR- Applikationen in der klinischen Anwendung weit verbreitet sind. Der in den "normalen" MR-Bildern vorliegende Kontrast beruht auf einer Kombination von unterschiedlichen physikalischen Parametern des zugrundeliegenden Gewebes und der verwendeten Aufnahmetechnik. Eine Mischung dieser Faktoren bestimmt dann den erreichten Bildkontrast.

Eine weitere Möglichkeit, Kontrastinformationen von biologischem Gewebe zu erhalten besteht darin, die zugrundeliegenden physikalischen oder physiologischen Eigenschaften zu messen, beispielsweise die T1-Zeit, die T2-Zeit oder die Protonendichte. Diese Techniken sind als Parameterbildgebung oder quantitative Bildgebung bekannt. Bei diesem Ansatz sind die erzeugten MR-Bilder unabhängig von der verwendeten MR-Anlage, der angewendeten Bildgebungstechnik und der verwendeten Bildgebungsparameter. Dadurch können die verschiedenen Ergebnisse besser verglichen werden, die klinische Diagnose wird verbessert. Die quantitativen MR-Bilder eröffnen die Möglichkeit, ein absolutes Maß für die verwendeten physikalischen Parameter zu bestimmen, wodurch die Abhängigkeit von dem Bildkontrast, der von vielen verschiedenen Faktoren abhängt, geringer wird.

Beispielsweise ist es mit der quantitativen Messung der T2-Relaxationszeit möglich, klinisch relevante Pathologien genauer und zuverlässiger zu erkennen, beispielsweise neurodegenerative Krankheiten oder Entzündungen im Gehirn. Weiterhin können Veränderungen im Knorpel oder pathologische Veränderungen des Herzmuskels besser erkannt werden.

Obwohl die Verwendung von quantitativen MR-Bildern seit längerem bekannt ist, werden sie in der klinischen Routine nur selten verwendet, was unter anderem an den beiden folgenden Problemen liegt:

a) Die Erstellung von quantitativen MR-Bildern ist typischerweise sehr zeitaufwendig. Bei der Erstellung der quantitativen MR-Bilder erfolgt üblicherweise ein Fit eines analytischen Signalmodells an die aufgenommenen MR-Daten, um daraus dann die quantitative Information wie die T2- oder T1-Zeit zu berechnen. Für einen gut funktionierenden Fit sind jedoch mehrere Datenpunkte notwendig. Beispielsweise ist es notwendig, für die quantitative Bestimmung der T2-Zeit mehrere Spin-Echos zu verschiedenen Echozeiten aufzunehmen, um den exponentiellen Signalverlauf der T2-Zeit zu modellieren. Dies führt insgesamt zu sehr langen Messzeiten.

b) Die räumliche Auflösung, die bei der Erstellung von quantitativen MR-Bildern erreichbar ist, ist begrenzt. Bei 2-D-Bildakquisitionen verringert sich die Signalintensität, wenn die Schichtdicke, d.h. die räumliche Auflösung in Richtung senkrecht zur Schichtebene verringert wird, wodurch das Signalrauschen im Bild erhöht wird. Ein weiterer Effekt der sich auf die Quantifizierung auswirkt, besteht darin, dass die Schichtprofile der angeregten 2-dimensionalen Schichten bei dünneren Schichten nicht perfekt rechteckig sind, wodurch wiederum ein Messfehler auftreten kann. Diese Effekte wirken sich negativ auf das Fit-Verfahren aus und somit auf die Genauigkeit des Algorithmus und der bestimmten MR-Parameter. Einige quantitative MR-Bildaufnahmetechniken sind auf 2-dimensionale Akquisitionen begrenzt und können nicht einfach auf drei Dimensionen ausgeweitet werden, beispielsweise eine Spin-Echo-Sequenz, sodass es nicht möglich ist, dadurch das Signalrauschverhältnis zu erhöhen. Eine Anwendung bei 3-D-Techniken ist beispielsweise aufgrund der spezifischen Absorptionsrate, SAR, begrenzt, da bei 3-D-Anwendungen sonst Gewebe mit zu viel Energie ausgesetzt werden würde.

Bisher war es nur möglich eine der oben unter a) oder b) genannten Probleme zu lösen.

Die MR-Signale werden im sogenannten Rohdatenraum oder K-Raum aufgenommen, und es ist bekannt, dass eine gewisse Datenmenge notwendig ist, um die Bilder artefaktfrei (d.h. ohne Aliasing Artefakte) zu rekonstruieren. Diese Bedingung ist unter dem Namen Nyquist-Theorem bekannt. Jedoch ist es möglich, dass ein Teil der aufgenommenen MR-Daten redundant ist und andere Kenntnisse verwendet werden, um Teile des Rohdatenraums nicht mit gemessenen, sondern mit rekonstruierten Rohdaten zu füllen. Eine Möglichkeit für die Berechnung von Rohdatenpunkten bei nicht vollständig aufgenommenen Rohdatenräumen besteht darin, einen modellbasierten Ansatz zu verwenden, wobei mithilfe des Modells nicht aufgenommene Rohdatenpunkte rekonstruiert werden können. Ein Beispiel eines derartigen Verfahrens ist unter dem Namen MARTINI "Model-based Accelerated Relaxometry by Iterative Non-linear Inversion" bekannt, bei dem es sich um ein iteratives Bildrekonstruktionsverfahren handelt, das ein Signalmodell verwendet. Ein Beispiel ist beschrieben in Sumpf, Tilmann J., et al. "Model-based nonlinear inverse reconstruction for T2 mapping using highly undersampled spin-echo MRI" Journal of Magnetic Resonance Imaging 34.2 (2011): 420-428. Hier wird beispielsweise der monoexponentielle Signalzerfall als Kenntnis verwendet, um die nicht gemessenen MR-Rohdatenpunkte zu rekonstruieren und anschließend einen T2-Wert zu bestimmen. Jedoch wird das Signal-zu-Rausch-Verhältnis typischerweise vermindert, wenn der Rohdatenraum nicht vollständig aufgenommen wird. Dieser Verlust im Signal-zu-Rausch-Verhältnis vermindert die Möglichkeit, eine hohe Auflösung bei der Erstellung der quantitativen MR-Bilder zu erreichen. Somit ist ein eventuelles, oben unter a) genanntes Problem gelöst, jedoch vergrößert sich das unter b) genannte Problem.

Andere iterative Bildrekonstruktionsverfahren sind beispielsweise in US 9,275,294 B2, US 9,285,448 B2 und US 9,035,653 B2 beschrieben.

Um die räumliche Auflösung bei 2-D-Aufnahmen zu vergrößern, kann die Pulsbandbreite und/oder die Amplitude des Schichtselektionsgradienten verändert werden, um die Schichtdicke zu verringern. Damit werden jedoch weniger Spins angeregt, was die Amplitude des empfangenen Signals verringert, und somit zu einem geringeren Signal-zu-Rausch-Verhältnis führt. Aus diesem Grund beträgt die Schichtdicke bei herkömmlichen 2-D-Bildaufnahmetechniken 2 mm oder mehr. Höhere Auflösungen sind mit 3-D-Bildaufnahmetechniken möglich, bei denen nichtselektive HF-Pulse verwendet werden um ein Anregungsvolumen von mehreren cm dicke anzuregen. Diese nichtselektiven HF-Pulse regen alle Spins im Messfeld an, was zu einem erhöhten Signal führt und damit zu einem erhöhten Signal-zu-Rausch-Verhältnis. Jedoch setzen diese nichtselektiven HF-Pulse sehr viel Energie im Untersuchungsobjekt aus, sodass die bestehenden Grenzen für SAR-Werte bei Menschen übertroffen werden. Bei der Erstellung von 3-dimensionalen quantitativen T2-Bildern mit der klassischen Spin-Echo-Technik werden diese SAR-Grenzwerte relativ schnell erreicht, da große Kippwinkel bei den HF-Pulsen verwendet werden, wodurch viel Energie im Körper ausgesetzt wird.

Alternativ hierzu existieren sogenannte Superresolution-Rekonstruktionen, wie sie beispielsweise bei Greenspan H, et al. in "MRI inter-slice reconstruction using super-resolution" in Magn. Reson. Imaging 2002;20: 437-446 beschrieben ist. Bei einem derartigen Verfahren werden mehrere 2-D-Schichten mit einer geringen Auflösung senkrecht zur Schichtebene aufgenommen, wobei jede Schicht geringfügig zu den anderen Schichten senkrecht zur Schichtebene verschoben ist. Anschließend werden die überlappenden Schichten kombiniert zur Erzeugung von MR-Bildern mit einer höheren Auflösung in Schichtrichtung, d.h. senkrecht zur Schichtebene. Hiermit ist es auch möglich, hochaufgelöste T1-Parameterbilder zu erzeugen. Mit dieser Technik wird zwar das technische Problem der geringen räumlichen Auflösung behoben, jedoch vergrößert sich die Messzeit, sodass das oben unter a) genannte Problem nicht gelöst wird, da beispielsweise diese Messzeit bei bis zu 30 min liegt für die Erstellung von quantitativen MR-Bildern.

Ning Lipeng et al haben in "A joint compressed-sensing and super-resolution approach for very high-resolution diffusion imaging", Neuroimage, Bd. 125, Seiten 386-400 ein Verfahren zur Diffusionsbildgebung beschrieben, bei dem für den Diffusionstensor nur einige Diffusionrichtungen verwendet werden.

Es ist daher eine Aufgabe der vorliegenden Erfindung, die oben genannten Probleme zu lösen, insbesondere die oben unter a) und b) genannten Probleme gleichzeitig zu lösen, nämlich dass quantitative MR-Bilder erstellt werden können mit zufriedenstellender Auflösung in Schichtrichtung und einer nicht zu langen Aufnahmezeit.

Diese Aufgabe wird durch die Merkmale der unabhängigen Ansprüche gelöst. In den abhängigen Ansprüchen sind weitere Ausführungsformen beschrieben.

Gemäß einem ersten Aspekt wird ein Verfahren zur Erstellung von quantitativen MR-Bildern eines Untersuchungsobjekts gemäß Anspruch 1 bereitgestellt. Es wird unter anderem ein erster MR-Datensatz des Untersuchungsobjekts in einem unterabgetasteten Rohdatenraum aufgenommen, der nach der Nyquist-Bedingung nicht vollständig mit Rohdatenpunkten gefüllt ist. Die Aufnahme des Untersuchungsobjekts erfolgt in mehreren 2-dimensionalen Schichten, bei denen die Auflösung in einer Schichtebene der Schichten jeweils höher ist als senkrecht zur Schichtebene und wobei die mehreren 2-dimensionalen Schichten jeweils zueinander um einen Abstand verschoben sind, der kleiner ist als die Auflösung senkrecht zur Schichtebene. Weiterhin werden weitere MR-Rohdatenpunkte für den ersten MR-Datensatz rekonstruiert, die nicht aufgenommen wurden, wobei die Rekonstruktion mithilfe eines Modells unter Verwendung einer Kostenfunktion erfolgt, die minimiert wird und bei der die aufgenommenen Rohdatenpunkte mit den rekonstruierten, nicht aufgenommene Rohdatenpunkten verglichen werden. Die Kostenfunktion berücksichtigt nun erfindungsgemäß die Verschiebung der mehreren 2-dimensionalen Schichten relativ zueinander. Anhand des ersten MR-Datensatzes und der weiteren MR-Rohdatenpunkte wird ein hochaufgelöste MR-Datensatz bestimmt, der eine höhere Auflösung senkrecht zur Schichtebene als die mehreren 2-dimensionalen Schichten aufweist. Anschließend erfolgt die Bestimmung der quantitativen MR-Bilder unter Verwendung des hochaufgelösten MR-Datensatzes.

Bei diesem vorgeschlagenen Verfahren wird eine modellbasierte Rekonstruktion mit der Technik kombiniert, bei der die 2-dimensionalen Schichten zueinander um einen Abstand verschoben aufgenommen werden. Weiterhin berücksichtigt die Kostenfunktion, die bei der Modellierung verwendet wird, diese Verschiebung der 2-diemnsionalen Schichten relativ zueinander, so dass es möglich ist, die rekonstruierten, nicht aufgenommenen MR-Rohdatenpunkte mit hoher Genauigkeit zu bestimmen. Erfindungsgemäß werden beide oben unter a) und b) genannten Probleme gelöst, nämlich die Messzeit wird verkürzt durch Verwendung von unterabgetasteten MR-Daten, die beispielsweise mit dem Faktor, der zwischen 5 und 10 liegt, unterabgetastet sind. Weiterhin wird das oben unter b) genannte Problem gelöst mit der verbesserten Auflösung, sodass die erstellten quantitativen MR-Bilder auch in dieser Richtung eine zufriedenstellende Auflösung ähnlich wie die Auflösung in der Schichtebene haben.

Erfindungsgemäß erfolgt eine Verschiebung der Schichten relativ zueinander senkrecht zur Schichtrichtung, wobei die Schichten parallel zueinander liegen.

Es ist möglich bei dem oben genannten Verfahren einen geschätzten hochaufgelösten MR-Datensatz abzuschätzen, der eine höhere Auflösung senkrecht zur Schichtebene aufweist als der erste MR-Datensatz. Weiterhin wird die Auflösung des geschätzten hochaufgelösten MR-Datensatz reduziert zur Erstellung eines abgeschätzten niederaufgelösten MR-Datensatzes, der senkrecht zur Schichtebene die gleiche Auflösung aufweist, wie der erste MR-Datensatz. Der abgeschätzten niederaufgelöste MR-Datensatz kann dann mit dem ersten MR-Datensatz verglichen werden und es kann die Kostenfunktion minimiert werden, wobei die Differenz des abgeschätzten niederaufgelösten MR-Datensatzes und des ersten MR-Datensatzes minimiert wird.

Bei dem Modell kann mit dem geschätzten hochaufgelösten MR-Datensatz und der anschließenden Reduzierung der Auflösung und dem anschließenden Vergleich mit dem aufgenommen ersten MR-Datensatz festgestellt werden, wie gut der abgeschätzten hochaufgelöste MR-Datensatz ist. Durch die Minimierung der Differenz des abgeschätzten niederaufgelösten MR-Datensatzes und des ersten MR-Datensatzes ist es möglich, eine gute Abschätzung für den geschätzten hochaufgelösten MR-Datensatz zu erhalten.

Die Kostenfunktion, die bei dem Modell minimiert wird, kann beispielsweise einen Datenkonsistenzterm aufweisen, der ein Modell der Aufnahme des ersten MR-Datensatzes abgebildet. Dieser Datenkonsistenzterm hat nun einen Term der berücksichtigt, dass die mehreren 2-dimensionalen Schichten jeweils senkrecht zur Schichtebene zueinander um einen Abstand verschoben worden sind. Beispielsweise kann die Kostenfunktion und hier der Datenkonsistenzterm einen Verschiebeoperator aufweisen, der die Verschiebung der mehreren 2-dimensionalen Schichten um den Abstand beschreibt.

Weiterhin kann die Kostenfunktion einen Signalverlaufsterm aufweisen, der beschreibt bzw. modelliert, wie sich das MR-Signal bei der Aufnahme des ersten MR-Datensatzes in Abhängigkeit von der gewählten Bildgebungssequenz verhält. Dieser Signalverlaufsterm kann zusätzlich bei der Minimierung der Kostenfunktion berücksichtigt werden.

Zusätzlich kann die Kostenfunktion einen Bildterm aufweisen, der berücksichtigt bzw. modelliert, dass das in den MR-Bildern dargestellte Untersuchungsobjekt eine geringe Anzahl von Kanten beinhaltet. Dies ist beispielsweise insbesondere bei der Erstellung von quantitativen MR-Bilddaten des Gehirns gerechtfertigt, da außerhalb der Schädeldecke nur eine geringe Anzahl von Kanten vorhanden ist.

Die Kostenfunktion kann nun in einem iterativen Verfahren minimiert werden, wobei in einem ersten Durchlauf des iterativen Verfahrens nur der Datenkonsistenzterm minimiert wird ohne Verwendung des Signalverlaufsterms und des Bildterms. In einem ersten Durchlauf des iterativen Verfahrens kann dann ein erster hochaufgelöster MR-Datensatz bestimmt werden, der anschließend bei dem zweiten Durchlauf im Signalverlaufsterm und Bildterm verwendet wird für die Minimierung dieser beiden Terme.

Bei dem Bildterm kann beispielsweise eine Wavelet-Transformation durchgeführt werden um das Kantenbild zu erhalten. In diesem Kantenbild werden dann Koeffizienten entsprechend eines Schwellwertes entfernt bevor die inverse Wavelet-Transformation durchgeführt wird.

Weiterhin können der Bildterm und der Signalverlaufsterm jeweils mit einem Koeffizienten gewichtet werden in der Kostenfunktion, wobei die Koeffizienten angeben, wie stark der Bildterm und der Signalverlaufsterm jeweils in der Kostenfunktion gewichtet werden.

Die Erfindung betrifft ebenso die zugehörige MR-Anlage gemäß Anspruch 12, die eine Recheneinheit und eine Speichereinheit aufweist, wobei die Speichereinheit von der Recheneinheit ausführbare Informationen speichert und die MR-Anlage ausgebildet ist, bei der Ausführung der Steuerinformationen in der Recheneinheit die oben beschriebenen Schritte und die noch nachfolgend im Detail beschriebenen Schritte auszuführen.

Weiterhin ist ein Computerprogrammprodukt mit Programmmitteln gemäß Anspruch 14 vorgesehen, das direkt in eine Speichereinheit der programmierbaren Recheneinheit der MR-Anlage ladbar ist, um die oben genannten Schritte auszuführen, wenn die Programmmittel in der Recheneinheit ausgeführt werden. Weiterhin ist ein elektronisch lesbarer Datenträger gemäß Anspruch 15 mit darauf gespeicherten elektronisch lesbaren Steuerinformationen vorgesehen, die derart ausgebildet sind, dass sie bei Verwendung des Datenträgers in der Recheneinheit der MR-Anlage das oben beschriebene Verfahren durchführen. Die oben beschriebenen Merkmale sowie die nachfolgend beschriebenen Merkmale können nicht nur in den entsprechenden explizit dargelegten Kombinationen verwendet werden, sondern auch in weiteren Kombinationen, sofern es nicht explizit anders erwähnt ist und sofern die Kombinationen in den durch die Ansprüche definierten Schutzumfang der Erfindung fallen.

Die Erfindung wird nachfolgend unter Bezugnahme auf die beiliegenden Zeichnungen näher erläutert.

Fig. 1 zeigt schematisch eine MR-Anlage, mit der erfindungsgemäß quantitative MR-Bilder berechnet werden können.

Fig. 2 zeigt schematisch die Verschiebung der 2-dimensionalen Schichten zur Erzeugung eines hochaufgelösten MR-Datensatzes mit einer höheren Auflösung in Schichtrichtung.

Fig. 3 zeigt schematisch ein Ablaufdiagramm mit den Schritten zu iterativen Berechnung der quantitativen MR-Bilddaten.

Nachfolgend wird die vorliegende Erfindung anhand bevorzugter Ausführungsformen unter Bezugnahme auf die beiliegenden Zeichnungen näher erläutert. In den Figuren bezeichnen gleiche Bezugzeichen gleiche oder ähnliche Elemente. Weiterhin sind die Figuren schematische Darstellungen verschiedener Ausführungsformen der Erfindung. Die in den Figuren dargestellten Elemente sind nicht notwendigerweise maßstabsgetreu dargestellt und die in den Figuren dargestellten Elemente sind vielmehr derart wiedergegeben, dass ihre Funktion und ihr Zweck dem Fachmann verständlich werden. Die in den Figuren dargestellten Verbindungen zwischen funktionellen Einheiten und sonstigen Elementen können auch als indirekte Verbindungen implementiert werden, wobei die Verbindung drahtlos oder drahtgebunden sein kann. Funktionelle Einheiten können als Hardware, Software oder eine Kombination aus Hardware und Software implementiert werden.

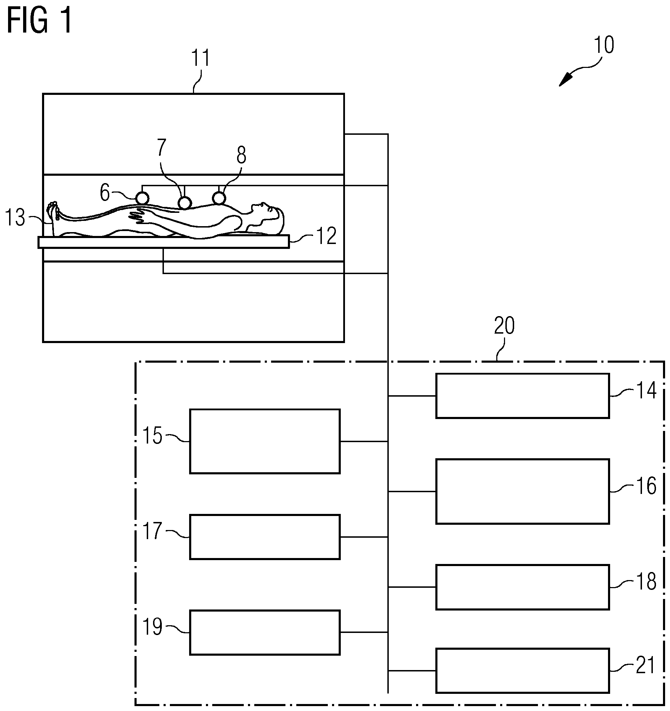

In Bezug auf Fig. 1 wird eine MR-Anlage 10 erläutert, mit der, wie nachfolgend erläutert wird, quantitative MR-Bilder aufgenommen werden können in guter räumlicher Auflösung in allen Dimensionen und innerhalb einer zeitlich zufriedenstellenden Aufnahmedauer.

Die MR-Anlage 10 weist einen Magneten 11 zur Erzeugung eines Polarisationsfelds B0 auf, wobei eine auf einer Liege 12 angeordnete Untersuchungsperson 13 in den Magneten 11 gefahren wird, um dort ortskodierte Magnetresonanzsignale aus der Untersuchungsperson aufzunehmen. Die zur Signalaufnahme verwendeten Spulen 6, 7 und 8 können für das Senden von HF-Pulsen verwendet werden sowie für die Aufnahme der MR-Signale. Eine eventuell vorhandene Ganzkörperspule der MR-Anlage 10 ist aus Übersichtlichkeitsgründen nicht dargestellt. Durch Einstrahlen von Hochfrequenzpulsen und Schalten von Magnetfeldgradienten kann die durch das Polarisationsfeld B0 erzeugte Magnetisierung aus der Gleichgewichtslage ausgelenkt und ortskodiert werden und die sich ergebende Magnetisierung wird von den Empfangsspulen 5-8 detektiert. Wie durch Einstrahlen der HF Pulse und durch Schalten von Magnetfeldgradienten in verschiedenen Kombinationen und Reihenfolgen MR-Bilder erzeugt werden können, ist dem Fachmann grundsätzlich bekannt und wird hier nicht näher erläutert.

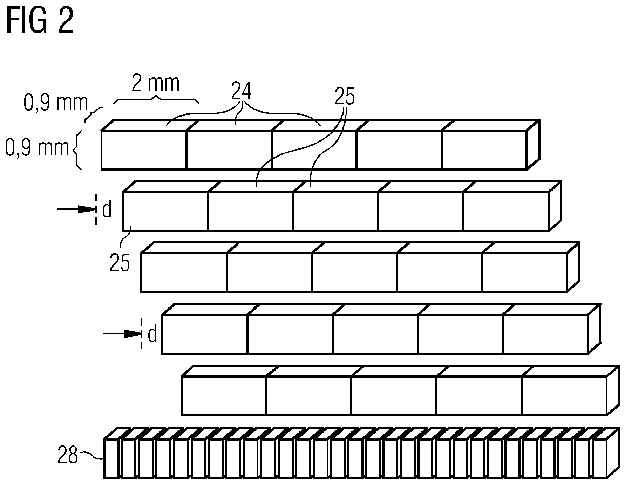

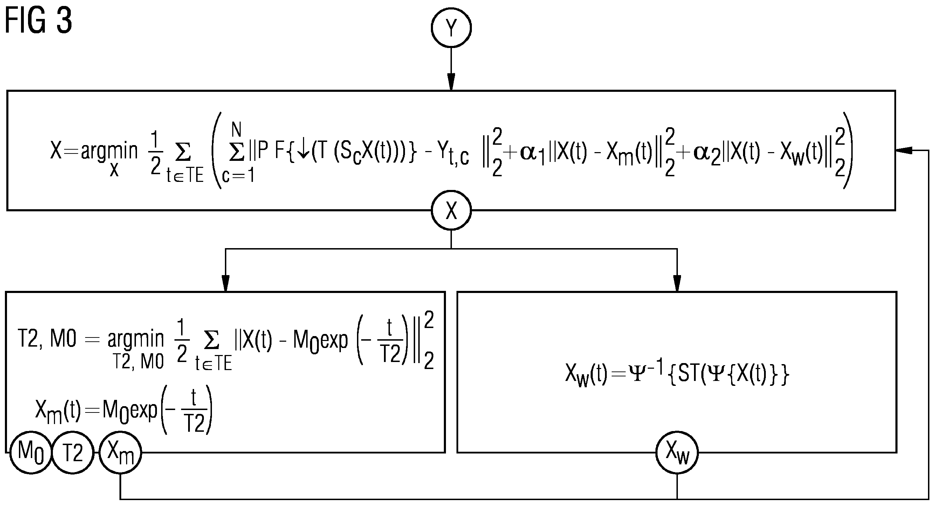

Die MR-Anlage weist weiterhin eine Steuereinheit 20 auf, die zur Steuerung der MR-Anlage verwendet werden kann. Die Steuereinheit 20 weist eine Gradientensteuereinheit 15 auf zur Steuerung und Schaltung der notwendigen Magnetfeldgradienten. Eine HF-Steuereinheit 14 ist vorgesehen für die Steuerung und Generierung der HF-Pulse zur Auslenkung der Magnetisierung aus der Gleichgewichtslage. Eine Bildsequenzsteuerung 16 steuert die Abfolge der Magnetfeldgradienten, der HF-Pulse und der Signalauslese und steuert damit auch indirekt die Gradientensteuereinheit 15 und die HF-Steuereinheit 14. Über eine Eingabeeinheit 17 kann eine Bedienperson die MR-Anlage steuern und auf eine Anzeigeeinheit 18 können MR-Bilder und sonstige zur Steuerung notwendigen Informationen angezeigt werden. Eine Recheneinheit 19 mit einer oder mehreren Prozessoreinheiten ist vorgesehen zur Steuerung der einzelnen funktionellen Einheiten. In einer Speichereinheit 21 können beispielsweise Programmmodule bzw. Programme abgespeichert werden, die, wenn sie von der Recheneinheit 19 bzw. ihrer Prozesseinheit ausgeführt werden, den Ablauf der MR-Anlage steuern können. Die Recheneinheit 19 kann insbesondere derart ausgebildet sein, dass aus den aufgenommenen MR-Signalen, wie nachfolgend in Zusammenhang mit Fig. 2 und 3 erläutert werden wird, quantitative MR-Bilder mit einem iterativen Verfahren berechnet werden.

In Fig. 2 ist schematisch dargestellt, wie aus mehreren 2-dimensionalen Schichten, die zueinander versetzt sind, ein Datensatz erzeugt werden kann, der eine höhere Auflösung senkrecht zur Schichtrichtung aufweist. In Fig. 2 sind Voxel 24 von aufgenommenen MR-Bilddaten dargestellt, wobei die Schichten parallel zueinander liegen und in der Schichtebene eine größere Auflösung aufweisen als senkrecht zur Schichtebene. Dies bedeutet, dass in der Schicht-bene die Bildpunkte ein kleineres Ausmaß haben als senkrecht zur Schichtrichtung. In Fig. 2 sind unterschiedliche Voxel 24 von 2-dimensionalen Schichten dargestellt, die parallel zueinander liegen mit einer Schichtdicke von beispielsweise 2 mm. In der Schichtebene hat das Voxel beispielsweise eine Auflösung von $0,9 \times 0,9$ mm.

Diese mehreren 2-dimensionalen Schichten mit den Voxeln 24 werden nun um einen Abstand D in Schichtrichtung verschoben, beispielsweise um 0,4 mm, wodurch sich die Lage der Voxel 25 wie gezeigt ergibt. Dieser Schritt kann wiederholt werden, im dargestellten Fall fünfmal, wodurch sich ein hochaufgelöster MR-Bilddatensatz 28 ergibt, der eine höhere Auflösung hat als der MR-Datensatz, der gemessen wurde. Der aufgenommenen MR- Datensatz mit den Voxeln 24 oder 25, nachfolgend auch erster MR-Datensatz genannt, wird mit einer hohen Unterabtastung aufgenommen, beispielsweise mit einer fünffachen, siebenfachen oder zehnfachen Unterabtastung. Bei der Rekonstruktion von quantitativen MR-Bildern kann nun vorgegangen werden, wie es näher in Zusammenhang mit Fig. 3 erläutert wird. Es wird ein hochaufgelöster MR-Datensatz, ein Bilddatensatz, abgeschätzt, der nachfolgend auch als geschätzter hochaufgelöster MR-Datensatz bezeichnet wird. Dieser hochaufgelöste geschätzte MR-Datensatz X wird abgeschätzt durch Minimierung einer Modellfunktion, die nachfolgend als Gleichung (1) beschrieben ist.

Gleichung (1):

$$X = \underset{x}{argmin} \frac{1}{2} \sum_{t \in TE} \left( \sum_{c=1}^{N} \left\| P\,F\left\{ \downarrow \left( T(S_c X(t)) \right) \right\} - Y_{t,c} \right\|_2^2 + \alpha_1 \left\| X(t) - X_m(t) \right\|_2^2 + \alpha_2 \left\| X(t) - X_m(t) \right\|_2^2 \right)$$

In obiger Gleichung (1) ist X der hochaufgelöste MR-Datensatz, Y bezeichnet den aufgenommenen ersten MR-Datensatz mit geringer Auflösung, wobei S die Spulensensitivitäten bedeuten. Der Operator T bezeichnet die Verschiebung der Schichten wie in Fig. 2 erläutert zwischen den Aufnahmen um den Abstand d.

T beschreibt einen Verschiebeoperator, der die Verschiebung der mehreren 2-dimensionalen Schichten um den Abstand definiert. Der Pfeil nach unten bedeutet, dass aus dem hochaufgelösten MR-Datensatz, wie er durch die Verschiebung senkrecht zur Schichtebene entstanden ist, ein abgeschätzter niedrigaufgelöster MR-Datensatz erstellt wird, der dann mit den gemessenen MR-Daten Y, dem ersten MR-Datensatz verglichen wird. F ist die Fourier-Transformation und P die Unterabtastmaske. $\alpha_1$ und $\alpha_2$ sind Faktoren, mit denen jeweils der Signalverlaufsterm, der nachfolgend beschrieben wird, gewichtet wird bzw. der Bildterm, der nachfolgend ebenfalls näher beschrieben wird. Da bei einem ersten Durchlauf durch die Iteration der abgeschätzte hochaufgelöste MR-Datensatz noch nicht bekannt ist, werden $\alpha_1$ und $\alpha_2$ im ersten Durchlauf Null gesetzt. Nach einem ersten Durchlauf ergibt sich eine erste Abschätzung für den hochaufgelösten MR-Datensatz. Die Fourier Transformation wird verwendet um besagten Datensatz in den K-Raum zu transformieren um diesen mit Y zu vergleichen. Wenn dieser geschätzte hochaufgelöste MR-Datensatz im ersten Durchlauf ein erstes Mal abgeschätzt wurde, kann mit den folgenden Gleichungen (2) und (3) der Signalverlaufsterm bzw. der Bildterm berechnet werden.

Gleichung(2):

$$T2, M0 = \underset{T2, M0}{argmin} \frac{1}{2} \sum_{t \in TE} \left\| X(t) - M_0 exp\left( -\frac{t}{T2} \right) \right\|_2^2$$

Gleichung (3):

$$X_m(t) = M_0 exp\left( -\frac{t}{T2} \right)$$

Der Signalverlaufsterm modelliert den Signalverlauf des MR-Signals in Abhängigkeit von der verwendeten Bildgebungssequenz. Im dargestellten Fall werden s.g. T2-Parameterbilder erzeugt, sodass in den Gleichungen (2) und (3) der monoexponentielle Abfall der T2-Zeit nach Anregung der Magnetisierung beschrieben ist. Im Falle der Berechnung einer T1-Karte werden in diesen Gleichungen (2) und (3) die entsprechenden bekannten Signalverläufe zur Bestimmung der T1-Zeit verwendet. Aus den Gleichungen (2) und (3) ergeben sich somit die Größe $M_0$, die Grundmagnetisierung, die T2-Zeit und $X_m$, wobei $X_m$ dem Signalverlauf bei der verwendeten Bildgebungssequenz entspricht. $X_m$ wird berechnet durch Anfitten eines monoexponentiellen Abfalls auf X, was zu der Abschätzung der T2-Zeit und von der Grundmagnetisierung $M_0$ führt.

Weiterhin kann nach dem ersten Durchlauf der Bildterm berechnet werden. Der Bildterm berücksichtigt, dass das in den MR-Bildern dargestellte Untersuchungsobjekt nur eine geringe Anzahl von Kanten aufweist, wie es beispielsweise im Gewebe innerhalb des Gehirns und innerhalb der Gehirnschale der Fall ist. Dieser zweite Term beschreibt die s.g. "Sparsity" der aufgenommenen MR-Daten.

Gleichung (4):

$$X_w(t) = \Psi^{-1}\{ST(\Psi\{X(t)\})\}$$

$X_w$, das regularisierte Bild, wird berechnet durch Anwenden einer Wavelet-Transformation, wobei auf das Wavelet transformierte Bild ein weicher Schwellenwert ST angewendet wird. Das Anwenden dieses Schwellenwerts führt dazu, dass Wavelet-Koeffizienten entfernt werden, womit die gewünschte "Sparsity" erreicht wird. Im Nachhinein werden die verbleibenden Wavelet-Koeffizienten mit einer inversen Wavelet-Transformation wieder in den Bildraum verwandelt um eine Abschätzung Xw zu erhalten welche der "Sparsity" entspricht.

Nach Berechnung der Bilder $X_m$ und $X_w$ können nun in jede weitere Iteration diese Werte in Gleichung (1) eingesetzt werden zur Berechnung des hochauflösenden Bilddatensatzes X. Durch die Wahl von $\alpha_1$ und $\alpha_2$ kann festgelegt werden, wie stark der sogenannte Signalverlaufsterm bzw. Bildterm gewichtet werden soll, zum Beispiel $\alpha_1 = 0.9$ und $\alpha_2 = 0.2$. Die Iteration kann anschließend wiederholt werden, beispielsweise eine definierte Anzahl von Wiederholungen, die zwischen 30 und 70 liegt. Weiterhin ist es möglich, dass die Iteration so lange wiederholt wird, bis der Unterschied zwischen den Ergebnissen der Iteration in den Bildern kleiner als ein Grenzwert ist.

Für die Minimierung der Kostenfunktion kann beispielsweise ein "Conjugate Gradient Descent" Algorithmus verwendet werden, der als numerisches Verfahren zur Lösung von Gleichungssystemen bekannt ist.

Das Ergebnis der Simulation ist ein hochaufgelöster MR-Datensatz, ein Bilddatensatz, der dann für die Berechnung der T2-Zeiten verwendet werden kann, die T2-Zeiten und die zugehörigen Parameterbilder können wie üblich berechnet werden.

Wie oben erläutert wurde, wurde das Verfahren der s.g. Super-resolution mit der Verschiebung senkrecht zur Schichtebene direkt in die Kostenfunktion der modellbasierten Rekonstruktion integriert, da sowohl der unterabgetastete Akquisitionsprozess und die Kombination des ersten MR-Datensatzes mit dem hochaufgelösten MR-Datensatz berücksichtigt wird. Dadurch ist es möglich, quantitative MR-Bilder in guter Auflösung und akzeptabler Aufnahmezeit zu bestimmen. Die Aufnahmezeit liegt in akzeptabler Größenordnung, da die MR-Daten in hohem Maße unterabgetastet werden. Die Rekonstruktion wird verbessert durch zusätzliche Berücksichtigung des Signalverlaufs in dem Signalverlaufsterm. Das in obigen Gleichungen beschriebene Problem kann mit der iterativen Rekonstruktion gelöst werden. Das beschriebene Modell ist ein nicht-linear, nicht-konvexes Optimierungsproblem. Durch die vorgeschlagene Trennung und die Einzeloptimierung der einzelnen Terme wird eine schnelle Konvergenz des Optimierungsproblems erreicht.

In der oben beschriebenen Ausführungsform wurde das Verfahren verwendet zur Bestimmung von quantitativen T2-Bildern. Wie schon erwähnt kann das beschriebene Verfahren jedoch auch für die Berechnung von anderen quantitativen MR-Parametern verwendet werden, beispielsweise für die Berechnung der T1-, T2*-Zeit, der Diffusion, für den Magnetisierungstransfer, für den Myelin-Wasseranteil, die Größe des Polarisationsfeldes B0 oder der Radiofrequenzfelder B1, wobei in Abhängigkeit von der zu quantifizierenden Größe der Signalverlaufsterm angepasst werden muss. Im dargestellten Fall wurde eine Verschiebung in Schichtrichtung als Änderung des Gesichtsfelds verwendet. Alternativ hierzu können andere Verschiebungsrichtungen oder Rotationen verwendet werden, um von dem ersten niedrigaufgelösten MR-Datensatz auf den hochaufgelösten MR-Datensatz zu kommen. Der Operator T muss dann entsprechend angepasst werden an die verwendete Verschiebung. Die Operation des Bildterms war in der beschriebenen Ausführungsform ein weicher Grenzwert in dem Wavelet-Bereich. Alternativ kann der Bildterm auch weggelassen werden oder es können weitere Bildterme verwendet werden, beispielsweise Varianten, die unter dem Namen Total Variation, Low-Rank oder Tikonov bekannt sind.

Die oben beschriebene Aufteilung in die drei verschiedenen Terme ist nicht zwingendermaßen notwendig für die Optimierung, und für die Optimierung können andere Algorithmen verwendet werden, wie der Gauß-Newton-Optimierungsalgorithmus oder ein Verfahren, das unter dem Namen "Golden Section Search" bekannt ist.

**Patentansprüche**

1. Verfahren zur Erstellung von quantitativen MR-Bildern eines Untersuchungsobjekts, in denen ein quantitativ ermittelter MR-Parameter dargestellt wird, mit den folgenden Schritten:

    - Aufnehmen von einem ersten MR-Datensatz des Untersuchungsobjekts in einem unterabgetasteten Rohdatenraum, der nach dem Nyquist-Theorem nicht vollständig mit Rohdatenpunkten gefüllt ist, wobei die Aufnahme des Untersuchungsobjekts in mehreren 2-dimensionalen parallelen Schichten erfolgt, bei denen die Auflösung in einer Schichtebene der Schichten jeweils höher ist als senkrecht zur Schichtebene, wobei die mehreren 2-dimensionalen Schichten jeweils zueinander senkrecht zur Schichtebene um einen Abstand verschoben sind, der geringer ist als die Auflösung senkrecht zur Schichtebene, und jede der mehreren 2-dimensionalen Schichten unterabgetastet ist,
    - Rekonstruieren von weiteren MR-Rohdatenpunkten des ersten MR-Datensatzes, die nicht aufgenommen wurden, mit Hilfe eines Modells unter Verwendung einer Kostenfunktion, die minimiert wird und bei der die aufgenommenen Rohdatenpunkte mit den rekonstruierten, nicht aufgenommenen Rohdatenpunkten verglichen werden, wobei die Kostenfunktion die Verschiebung der mehreren 2-dimensionalen Schichten senkrecht zur Schichtebene berücksichtigt, wobei anhand des ersten MR-Datensatzes und der weiteren MR-Rohdatenpunkte ein hochaufgelöster MR-Datensatz bestimmt wird, der eine höhere Auflösung senkrecht zur Schichtebene als die mehreren 2-dimensionalen Schichten aufweist,
- Bestimmen der quantitativen MR-Bilder unter Verwendung des hochaufgelösten MR-Datensatzes.

2. Verfahren nach Anspruch 1, weiterhin umfassend die Schritte:

- Abschätzen eines geschätzten hochaufgelösten MR-Datensatzes, der eine höhere Auflösung senkrecht zur Schichtebene aufweist als der erste MR-Datensatz,
- Reduzieren der Auflösung des geschätzten hochaufgelösten MR-Datensatzes zur Erstellung eines abgeschätzten niederaufgelösten MR-Datensatzes, der senkrecht zur Schichtebene die gleiche Auflösung aufweist, wie der erste MR-Datensatz,
- Vergleichen des abgeschätzten niederaufgelösten MR-Datensatzes mit dem ersten MR-Datensatz,
- Minimieren der Kostenfunktion, wobei die Differenz des abgeschätzten niederaufgelösten MR-Datensatzes und des ersten MR-Datensatzes minimiert wird.

3. Verfahren nach Anspruch 2, **dadurch gekennzeichnet, dass** die Kostenfunktion einen Datenkonsistenzterm aufweist, der ein Modell der Aufnahme des ersten MR-Datensatzes abbildet, wobei der Datenkonsistenzterm berücksichtigt, dass die mehreren 2-dimensionalen Schichten jeweils senkrecht zur Schichtebene zueinander um den Abstand verschoben sind.

4. Verfahren nach einem der vorstehenden Ansprüche, wobei die Kostenfunktion einen Signalverlaufsterm aufweist, der beschreibt, wie sich das MR-Signal bei der Aufnahme des ersten MR-Datensatzes verhält, wobei dieser Signalverlaufsterm zusätzlich bei der Minimierung der Kostenfunktion berücksichtigt wird.

5. Verfahren nach einem der vorstehenden Ansprüche, wobei die Kostenfunktion einen Bildterm aufweist, der berücksichtigt, dass in den MR-Bildern die Voraussetzung der "Sparsity" erfüllt ist.

6. Verfahren nach Anspruch 3, 4 und 5, wobei bei der Minimierung der Kostenfunktion der Datenkonsistenzterm, der Signalverlaufsterm und der Bildterm einzeln minimiert werden.

7. Verfahren nach Anspruch 6, wobei die Kostenfunktion in einem iterativen Verfahren minimiert wird, wobei in einem ersten Durchlauf nur der Datenkonsistenzterm minimiert wird ohne Verwendung des Signalverlaufsterms und des Bildterms.

8. Verfahren nach Anspruch 7, wobei in dem ersten Durchgang ein erster hochaufgelöster MR-Datensatz bestimmt wird, der anschließend bei einem zweiten Durchgang in dem Signalverlaufsterm und dem Bildterm verwendet wird.

9. Verfahren nach einem der vorstehenden Ansprüche, wobei die Kostenfunktion einen Verschiebungsoperator aufweist, der die Verschiebung der mehreren 2-dimensionalen Schichten um den Abstand beschreibt.

10. Verfahren nach einem der Ansprüche 5 bis 9, wobei bei dem Bildterm eine Wavelet-Transformation durchgeführt wird, wobei im transformierten Bereich ein Schwellwert angewendet wird, bevor eine Wavelet-Rücktransformation durchgeführt wird.

11. Verfahren nach einem der Ansprüche 5 bis 10, wobei der Bildterm und der Signalverlaufsterm jeweils mit einem Koeffizienten gewichtet werden, die angeben, wie stark der Bildterm und der Signalverlaufsterm jeweils in der Kostenfunktion gewichtet werden.

12. MR-Anlage (10), die ausgebildet ist zur Erstellung von quantitativen MR-Bildern eines Untersuchungsobjekts , in denen ein quantitativ ermittelter MR-Parameter dargestellt wird, wobei die MR-Anlage eine Recheneinheit (19) und eine Speichereinheit (21) aufweist, wobei die Speichereinheit (21) von der Recheneinheit (19) ausführbare Steuerinformationen speichert, wobei die MR-Anlage ausgebildet ist, bei Ausführung der Steuerinformationen in der Recheneinheit folgende Schritte auszuführen:

- Aufnehmen von einem ersten MR-Datensatz des Untersuchungsobjekts in einem unterabgetasteten Rohdatenraum, der nach dem Nyquist-Theorem nicht vollständig mit Rohdatenpunkten gefüllt ist, wobei die Aufnahme des Untersuchungsobjekts in mehreren 2-dimensionalen parallelen Schichten erfolgt, bei denen die Auflösung in einer Schichtebene der Schichten jeweils höher ist als senkrecht zur Schichtebene, wobei die mehreren 2-dimensionalen Schichten jeweils zueinander senkrecht zur Schichtebene um einen Abstand verschoben sind, der geringer ist als die Auflösung senkrecht zur Schichtebene, und jede der mehreren 2-dimensionalen Schichten unterabgetastet ist,

- Rekonstruieren von weiteren MR-Rohdatenpunkten des ersten MR-Datensatzes, die nicht aufgenommen wurden, mit Hilfe eines Modells unter Verwendung einer Kostenfunktion, die minimiert wird und bei der die aufgenommenen Rohdatenpunkte mit den rekonstruierten, nicht aufgenommenen Rohdatenpunkten verglichen werden, wobei die Kostenfunktion die Verschiebung der mehreren 2-dimensionalen Schichten senkrecht zur Schichtebene berücksichtigt, wobei anhand des ersten MR-Datensatzes und der weiteren MR-Rohdatenpunkte ein hochaufgelöster MR-Datensatz bestimmt wird, der eine höhere Auflösung senkrecht zur Schichtebene als die mehreren 2-dimensionalen Schichten aufweist,

- Bestimmen der quantitativen MR-Bilder unter Verwendung des hochaufgelösten MR-Datensatzes.

**13.** MR-Anlage nach Anspruch 12, wobei die MR-Anlage ausgebildet ist bei Ausführung der Steuerinformationen in der Recheneinheit ein Verfahren nach einem der Ansprüche 2 bis auszuführen.

**14.** Computerprogrammprodukt, welches Programmmittel umfasst und direkt in eine Speichereinheit einer programmierbaren Steuereinheit einer MR-Anlage ladbar ist, um alle Schritte des Verfahrens nach einem der Ansprüche 1-11 auszuführen, wenn die Programmmittel in der Recheneinheit ausgeführt werden.

**15.** Elektronisch lesbarer Datenträger mit darauf gespeicherten elektronisch lesbaren Steuerinformationen, welche derart ausgestaltet sind, dass sie bei Verwendung des Datenträgers in einer Recheneinheit einer MR-Anlage das Verfahren nach einem der Ansprüche 1-11 durchführen.

**Claims**

**1.** Method for generating quantitative MR images of an object under investigation, in which a quantitatively determined MR parameter is represented, having the following steps:

- capturing a first MR data set of the object under investigation in an undersampled raw data space, which according to the Nyquist theorem is incompletely filled with raw data points, wherein the object under investigation is captured in a plurality of 2-dimensional parallel slices, in which the resolution in a slice plane of the slices is in each case higher than perpendicular to the slice plane, wherein the plurality of 2-dimensional slices are in each case shifted relative to one another perpendicular to the slice plane by a distance which is smaller than the resolution perpendicular to the slice plane, and each of the plurality of 2-dimensional slices is undersampled,

- reconstructing further MR raw data points of the first MR data set, which were not captured, with the assistance of a model using a cost function which is minimised and in which the captured raw data points are compared with the reconstructed raw data points which were not captured, wherein the cost function takes account of the shift of the plurality of 2-dimensional slices perpendicular to the slice plane, wherein a high-resolution MR data set is determined on the basis of the first MR data set and the further MR raw data points, which high-resolution MR data set has a higher resolution perpendicular to the slice plane than the plurality of 2-dimensional slices,

- determining the quantitative MR images using the high-resolution MR data set.

**2.** Method according to claim 1, furthermore comprising the steps:

- estimating an estimated high-resolution MR data set which has a higher resolution perpendicular to the slice plane than the first MR data set,

- reducing the resolution of the estimated high-resolution MR data set in order to generate an estimated low-resolution MR data set which has the same resolution perpendicular to the slice plane as the first MR data set,

- comparing the estimated low-resolution MR data set with the first MR data set,

- minimising the cost function, wherein the difference between the estimated low-resolution MR data set and the first MR data set is minimised.

**3.** Method according to claim 2, **characterised in that** the cost function has a data consistency term which maps a model of the capture of the first MR data set, wherein the data consistency term takes account of the plurality of 2-dimensional slices in each case being shifted relative to one another by the distance perpendicular to the slice plane.

**4.** Method according to one of the preceding claims, wherein the cost function has a signal curve term which describes how the MR signal behaves during capture of the first MR data set, wherein said signal curve term is additionally taken into account during minimisation of the cost function.

5. Method according to one of the preceding claims, wherein the cost function has an image term which takes account of the prerequisite of "sparsity" being met in the MR images.

6. Method according to claims 3, 4 and 5, wherein the data consistency term, the signal curve term and the image term are individually minimised during minimisation of the cost function.

7. Method according to claim 6, wherein the cost function is minimised in an iterative method, wherein in a first pass only the data consistency term is minimised without using the signal curve term and the image term.

8. Method according to claim 7, wherein a first high-resolution MR data set is determined in the first pass, which high-resolution MR data set is then used in a second pass in the signal curve term and the image term.

9. Method as claimed on one of the preceding claims, wherein the cost function has a shift operator which describes the shift of the plurality of 2-dimensional slices by the distance.

10. Method according to one of claims 5 to 9, wherein a wavelet transformation is carried out in the image term, wherein a threshold value is applied in the transformed region before a wavelet back-transformation is carried out.

11. Method according to one of claims 5 to 10, wherein the image term and the signal curve term are in each case weighted with a coefficient, which coefficients indicate how heavily the image term and the signal curve term are each weighted in the cost function.

12. MR system (10) which is configured for generating quantitative MR images of an object under investigation, in which a quantitatively determined MR parameter is represented, wherein the MR system comprises a computing unit (19) and a memory unit (21), wherein the memory unit (21) stores control information executable by the computing unit (19), wherein the MR system is configured, on execution of the control information in the computing unit, to carry out the following steps:

- capturing a first MR data set of the object under investigation in an undersampled raw data space, which according to the Nyquist theorem is incompletely filled with raw data points, wherein the object under investigation is captured in a plurality of 2-dimensional parallel slices, in which the resolution in a slice plane of the slices is in each case higher than perpendicular to the slice plane, wherein the plurality of 2-dimensional slices are in each case shifted relative to one another by a distance which is smaller than the resolution perpendicular to the slice plane, and each of the plurality of 2-dimensional slices is undersampled,
- reconstructing further MR raw data points of the first MR data set, which were not captured, with the assistance of a model using a cost function which is minimised and in which the captured raw data points are compared with the reconstructed raw data points which were not captured, wherein the cost function takes account of the shift of the plurality of 2-dimensional slices perpendicular to the slice plane, wherein a high-resolution MR data set is determined on the basis of the first MR data set and the further MR raw data points, which high-resolution MR data set has a higher resolution perpendicular to the slice plane than the plurality of 2-dimensional slices,
- determining the quantitative MR images using the high-resolution MR data set.

13. MR system according to claim 12, wherein the MR system is configured to carry out a method according to one of claims 2 to 11 on execution of the control information in the computing unit.

14. Computer program product which comprises program means and can be loaded directly into a memory unit of a programmable control unit of an MR system in order to carry out all steps of the method according to one of claims 1-11 when the program means are executed in the computing unit.

15. Electronically readable data storage medium with electronically readable control information stored thereon, which information is designed such that, on using the data storage medium in a computing unit of an MR system, it carries out the method according to one of claims 1-11.

**Revendications**

1. Procédé d'établissement d'images RM quantitatives d'un objet à examiner, dans lesquelles on représente un paramètre RM déterminé quantitativement, comprenant les stades suivants :

   - enregistrement d'un premier ensemble de données RM de l'objet à examiner dans un espace de données brutes sous-échantillonnées, qui, suivant la théorème de Nyquist, n'est pas rempli complètement de points de données brutes, dans lequel l'enregistrement de l'objet à examiner s'effectue en plusieurs couches parallèles en deux dimensions, dans lesquelles la résolution dans un plan de couche des couches est respectivement plus grande que perpendiculairement au plan de couches, dans lequel les plusieurs couches en 2 dimensions sont respectivement perpendiculairement au plan de couche, décalées d'une distance, qui est plus petite que la résolution perpendiculairement au plan de couche, et chacune des plusieurs couches en 2 dimensions est sous-échantillonnée,
   - reconstruction d'autres points de données brutes RM du premier ensemble de données RM, qui n'ont pas été enregistrées, à l'aide d'un modèle en utilisant une fonction de coût que l'on minimise, et dans lequel on compare les points de données brutes enregistrés aux points de données brutes reconstruits, non enregistrés, dans lequel la fonction de coût tient compte du décalage des plusieurs couches en 2 dimensions perpendiculairement au plan de couche, dans lequel, à l'aide du premier ensemble de données RM et des autres points de données brutes RM, on définit un ensemble de données RM à haute résolution, qui a une résolution plus grande, perpendiculairement au plan de couche, que les plusieurs couches à 2 dimensions,
   - détermination d'images RM quantitatives en utilisant l'ensemble de données RM à haute résolution.

2. Procédé suivant la revendication 1, comprenant en outre les stades :

   - estimation d'un ensemble de données RM estimées à haute résolution, qui a une résolution plus grande perpendiculairement au plan de couche, que le premier ensemble de données RM,
   - réduction de la résolution de l'ensemble de données RM estimées à haute résolution pour l'établissement d'un ensemble de données RM estimé à basse résolution qui a, perpendiculairement au plan de couche, la même résolution que le premier ensemble de données RM,
   - comparaison de l'ensemble de données RM estimé à basse résolution au premier ensemble de données RM,
   - minimisation de la fonction de coût, dans lequel on minimise la différence entre l'ensemble de données RM estimé à basse résolution et le premier ensemble de données RM.

3. Procédé suivant la revendication 2, **caractérisé en ce que** la fonction de coût à un terme de cohérence de données, qui représente un modèle de l'enregistrement du premier ensemble de données RM, dans lequel le terme de cohérence de données tient compte du fait que les plusieurs couches à 2 dimensions sont décalées d'une distance entre elles, respectivement perpendiculairement au plan de couche.

4. Procédé suivant l'une des revendications précédentes, dans lequel la fonction de coût a un terme de courbe du signal, qui décrit comment le signal RM se comporte à la réception du premier ensemble de données RM, dans lequel on prend en compte ce terme de courbe du signal supplémentairement, lors de la minimisation de la fonction de coût.

5. Procédé suivant l'une des revendications précédentes, dans lequel la fonction de coût à un terme d'image, qui prend en compte le fait que dans les images RM la présomption de la « sparsity » est satisfaite.

6. Procédé suivant la revendication 3, 4 et 5, dans lequel, lors de la minimisation de la fonction de coût, on minimise individuellement le terme de cohérence de données, le terme de courbe du signal et le terme d'image.

7. Procédé suivant la revendication 6, dans lequel on minimise la fonction de coût suivant un procédé itératif, dans lequel, dans un premier passage, on ne minimise que le terme de cohérence de données, sans utilisation du terme de courbe du signal ni du terme d'image.

8. Procédé suivant la revendication 7, dans lequel, dans le premier passage, on définit un premier ensemble de données RM à haute résolution, que l'on utilise ensuite, lors d'un deuxième passage, dans le terme de courbe du signal et le terme d'image.

9. Procédé suivant l'une des revendications précédentes, dans lequel la fonction de coût a un opérateur de décalage, qui décrit le décalage, de la distance, des plusieurs couches à 2 dimensions.

10. Procédé suivant l'une des revendications 5 à 9, dans lequel on effectue, dans le terme d'image, une transformation d'ondelette, dans lequel on applique une valeur de seuil à la partie transformée, avant d'effectuer une retransformation d'ondelette.

11. Procédé suivant l'une des revendications 5 à 10, dans lequel on pondère le terme d'image et le terme de courbe du signal respectivement par un coefficient, qui indique de combien le terme d'image et le terme de courbe du signal sont pondérés respectivement dans la fonction de coût.

12. Installation (10) RM, qui est constituée pour l'établissement d'images RM quantitatives d'un objet à examiner, dans lesquelles un paramètre RM déterminé quantitativement est représenté, dans laquelle l'installation RM a une unité (19) informatique et une unité (21) de mémoire, dans laquelle l'unité (21) de mémoire met en mémoire les informations de commande pouvant être réalisées par l'unité (19) informatique, dans laquelle l'installation RM est constituée pour effectuer, lors de l'exécution des informations de commande dans l'unité informatique, les stades suivants :

- enregistrement d'un premier ensemble de données RM de l'objet à examiner dans un espace de données brutes sous-échantillonnées, qui, suivant la théorème de Nyquist, n'est pas rempli complètement de points de données brutes, dans lequel l'enregistrement de l'objet à examiner s'effectue en plusieurs couches parallèles en deux dimensions, dans lesquelles la résolution dans un plan de couche des couches est respectivement plus grande que perpendiculairement au plan de couches, dans lequel les plusieurs couches en 2 dimensions sont respectivement perpendiculairement au plan de couche, décalées d'une distance, qui est plus petite que la résolution perpendiculairement au plan de couche, et chacune des plusieurs couches en 2 dimensions est sous-échantillonnée,

- reconstruction d'autres points de données brutes RM du premier ensemble de données RM, qui n'ont pas été enregistrées, à l'aide d'un modèle en utilisant une fonction de coût que l'on minimise, et dans lequel on compare les points de données brutes enregistrés aux points de données brutes reconstruits, non enregistrés, dans lequel la fonction de coût tient compte du décalage des plusieurs couches en 2 dimensions perpendiculairement au plan de couche, dans lequel, à l'aide du premier ensemble de données RM et des autres points de données brutes RM, on définit un ensemble de données RM à haute résolution, qui a une résolution plus grande, perpendiculairement au plan de couche, que les plusieurs couches à 2 dimensions,

- détermination d'images RM quantitatives en utilisant l'ensemble de données RM à haute résolution.

13. Installation RM suivant la revendication 12, dans laquelle l'installation RM est constituée pour, à l'exécution des informations de commande dans l'unité informatique, effectuer un procédé suivant l'une des revendications 2 à 11.

14. Produit de programme d'ordinateur, qui comprend des moyens de programme et qui peut être chargé directement dans une unité de mémoire d'une unité de commande programmable d'une installation RM, pour effectuer tous les stades du procédé suivant l'une des revendications 1 à 11, lorsque les moyens de programme sont réalisés dans l'unité informatique.

15. Support de données, déchiffrable électroniquement, sur lequel sont mémorisées des informations de commande déchiffrables électroniquement, qui sont conformées de manière à ce qu'elles effectuent, lors de l'utilisation du support de données dans une unité informatique d'une installation RM, le procédé suivant l'une des revendications 1 à 11.

FIG 1

FIG 2

**FIG 3**

$$X = \underset{X}{\arg\min} \; \frac{1}{2} \sum_{t \in TE} \left( \sum_{c=1}^{N} \| P \, F\{\downarrow(T\,(S_c X(t)))\} - Y_{t,c} \|_2^2 + \alpha_1 \| X(t) - X_m(t) \|_2^2 + \alpha_2 \| X(t) - X_w(t) \|_2^2 \right)$$

$$T2, M0 = \underset{T2, M0}{\arg\min} \; \frac{1}{2} \sum_{t \in TE} \| X(t) - M_0 \exp\left(-\frac{t}{T2}\right) \|_2^2$$

$$X_m(t) = M_0 \exp\left(-\frac{t}{T2}\right)$$

$$X_w(t) = \Psi^{-1}\{ST(\Psi\{X(t)\})\}$$

EP 3 290 940 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 9275294 B2
- US 9285448 B2
- US 9035653 B2

**In der Beschreibung aufgeführte Nicht-Patentliteratur**

- **SUMPF, TILMANN J. et al.** Model-based nonlinear inverse reconstruction for T2 mapping using highly undersampled spin-echo MRI. *Journal of Magnetic Resonance Imaging,* 2011, vol. 34.2, 420-428
- **GREENSPAN H et al.** MRI inter-slice reconstruction using super-resolution. *Magn. Reson. Imaging,* 2002, vol. 20, 437-446
- **NING LIPENG et al.** A joint compressed-sensing and super-resolution approach for very high-resolution diffusion imaging. *Neuroimage,* vol. 125, 386-400